Europäisches Patentamt

European Patent Office

Office européen des brevets

(11) Veröffentlichungsnummer: **0 015 527**
**B1**

## (12) EUROPÄISCHE PATENTSCHRIFT

(45) Veröffentlichungstag der Patentschrift:
02.03.83

(21) Anmeldenummer: 80101050.5

(22) Anmeldetag: 03.03.80

(51) Int. Cl.³: **H 02 B 1/08,** H 05 K 7/14

(54) Vorrichtung zur Befestigung von Gerätekoffern in Gestellen.

(30) Priorität: **07.03.79 DE 2908811**

(43) Veröffentlichungstag der Anmeldung:
**17.09.80 Patentblatt 80/19**

(45) Bekanntmachung des Hinweises auf die Patenterteilung:
**02.03.83 Patentblatt 83/9**

(84) Benannte Vertragsstaaten:
**BE CH FR IT NL**

(56) Entgegenhaltungen:
**FR-A-2 372 375**
**US-A-3 381 064**

(73) Patentinhaber: **DORNIER GMBH, Postfach 1420,
D-7990 Friedrichshafen (DE)**

(72) Erfinder: **Frischknecht, Erich, Schlehenweg 12,
D-7990 Friedrichshafen 1 (DE)**

(74) Vertreter: **Landsmann, Ralf, Dipl.-Ing., Kleeweg 3,
D-7990 Friedrichshafen 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Vorrichtung zur Befestigung von Gerätekoffern in Gestellen

Die Erfindung betrifft eine Vorrichtung zur Befestigung von Gerätekoffern in Gestellen, mit einer daran vorgesehenen Profilleiste und einem darauf angeordneten, eine Haltenase aufweisenden und einen Rand des Gerätekoffers umfassenden Spannelement, wobei das Spannelement mittels einer Gewindespindel den Rand der Gerätekoffer verspannt.

Es ist bekannt, Gerätekoffer in stationären Fernmeldeanlagen oder mobilen Fernmeldekabinen mittels Verschraubungen in Gestellen zu befestigen. Aus dem Dokument US-A-3 831 064 ist eine derartige Vorrichtug zur Befestigung von elektrischen Bauelementen in einem Gestell bekannt. Eine Profilleiste ist mit einem darauf angeordneten, eine Haltenase aufweisenden Spannelement vorgesehen. Ein Rand des Bauelements wird dabei von der Haltenase umfaßt, wobei das mit einer Gewindespindel versehene Spannelement den einen Rand des Bauelements verspannt. Verschraubungen sind zwar leicht demontierbar, so daß die Gerätekoffer ausgetauscht werden können, weisen jedoch den Nachteil auf, daß hierzu in der Regel Schraubenschlüsse oder Schraubenzieher verwendet werden müssen und daß Schraubverbindungen nicht rüttelsicher sind, so daß zur Verwendung in mobilen Anlagen besondere Schraubensicherungen notwendig sind.

Der Erfindung liegt die Aufgabe zugrunde, eine Vorrichtung zu schaffen, mit welcher Gerätekoffer in mit einer Profilleiste versehenen Gestellen durch ein mit einer Haltenase versehenes Spannelement werkzeuglos, rüttel- und lösungssicher befestigbar sind.

Diese Aufgabe wird erfindungsgemäß dadurch gelöst, daß die Profilleiste mit einem Anschlag für den hinteren Rand der Gerätekoffer versehen ist, daß das Spannelement um eine Achse drehbar angelenkt ist, und daß der Anschlag und die Haltenase gegenüber den Gerätekoffern winklig verlaufende Flächen aufweisen.

Die Gerätekoffer weisen üblicherweise an ihrem Boden einen vorstehenden Rand auf, der mittels Schrägflächen, die sich an den Haltenasen des Anschlags und des Spannelements befinden, erfaßt wird und zwischen diesen Maschinenelementen eingespannt wird, ohne daß Verformungen des Bodens auftreten.

Erfindungsgemäß ist das Spannelement am Boden der Profilleiste drehbar befestigt und im zentralen Bereich des Spannelements befindet sich ein Langloch zur Aufnahme der Gewindespindel, deren Gegenlager innerhalb der Profilleiste angeordnet ist.

Bei einer vorteilhaften Ausführungsform der Erfindung ist die Gewindespindel mittels eines ausrastbaren Knebels betätigbar.

Weitere Vorteile, Merkmale und Anwendungsmöglichkeiten der Erfindung ergeben sich aus den Figuren, die nachfolgend beschrieben sind.

Es zeigt

Fig. 1 eine seitliche Schnittansicht der erfindungsgemäßen Vorrichtung und

Fig. 2 eine Draufsicht auf die Vorrichtung von Fig.1.

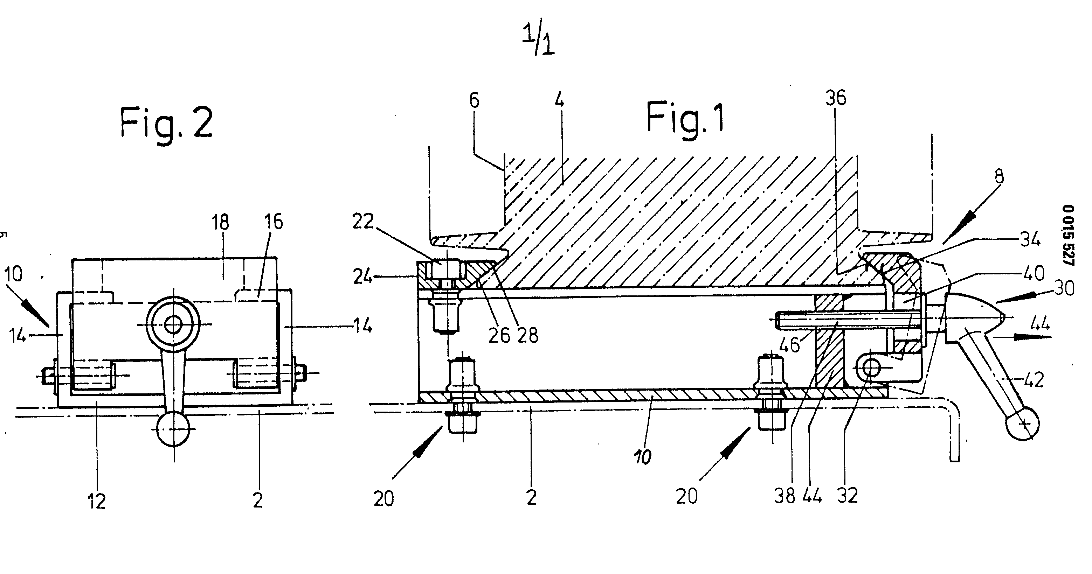

In Fig. 1 ist der Boden eines Gestells mit 2 bezeichnet. An diesem Boden soll ein Gerätekoffer 4 befestigt werden, von dem ein Teil seiner Begrenzung in gestrichelten Linien 6 argedeutet ist. Zur Befestigung der Gerätekoffer 4 dient nun die Befestigungsvorrichtung 8, die nachfolgend näher beschrieben wird.

Eine Profilleiste 10, die aus einem Boden 12, Seitenwänden 14 und einer Deckwand 16 mit Schlitz 18 (Fig. 2) besteht, wird mit Schrauben 20 am Gestellboden 2 befestigt. Am hinteren Ende der Deckwand ist mittels Schrauben 22 ein Anschlag 24 montiert, dessen winklig verlaufende Fläche 26 eine ebensolche Fläche 28 des Gerätekoffers 4 umgreift.

Am vorderen Ende der Profilleiste 10 befindet sich ein Spannelement 30, das in Nähe des Bodens der Profilleiste bei 32 drehbar angelenkt ist. An seinem oberen Ende weist das Spannelement eine oder mehrere Haltenasen auf, die im verspannten Zustand mit ihren winklig verlaufenden Flächen 34 gegen ebensolche Flächen 36 am Gerätekoffer 4 drücken. Zur Betätigung des Spannelements in eine Spindel 38 vorgesehen, die das Spannelement 30 in einem Langloch 40 im zentralen Bereich durchstößt und in einem Knebel 42 endet. Als Gegenlager für die Gewindespindel 38 ist ein Profilteil 44 mit Gewindeloch 46 in der Profilleiste 10 befestigt.

Durch Betätigung der Gewindespindel mittels des Knebels 42 wird das Spannelement 30 gegen den Gerätekoffer 4 gedrückt, so daß dieser fest und rüttelsicher eingespannt werden kann. Die Steigung der Gewindespindel 38 ist dabei so ausgelegt, daß Selbsthemmung auftritt. Es kann nun sein, daß sich der Knebel 42 bei Verspannung des Gerätekoffers in einer Lage befindet, die für den Betrieb hinderlich ist. Zur Vermeidung dieses Nachteils kann der Knebel 42 in Richtung des Pfeils 44 ausgerückt werden und dann in eine beliebige Lage verschwenkt werden. Vorzugsweise werden immer dann, wenn ein Gerätekoffer fest eingespannt ist, die Knebel in eine Lage verschwenkt, wie sie in Fig. 2 zu sehen ist. Dies bietet dem Betrachter auch eine optische Kontrolle dafür, daß die Gerätekoffer fest und rüttelsicher eingespannt sind.

Durch Versetzen des Anschlags 24 können Gerätekoffer 4 unterschiedlicher Tiefe eingespannt werden.

Bei Linksdrehung der Gewindespindel 38 öffnet Spannelement 30 selbsttätig, bedingt durch Schwerpunktlage und Drehpunkt des Spannelements und gibt den zu verspannenden Gerätekoffer 4 frei, ohne daß eine Druckfeder erforderlich ist.

## Patentansprüche

1. Vorrichtung zur Befestigung von Gerätekoffern in Gestellen mit einer daran vorgesehenen Profilleiste (10) und einem darauf angeordneten, eine Haltenase (34) aufweisenden und einen Rand des Gerätekoffers (4) umfassenden Spannelement (8), wobei das Spannelement (8) mittels einer Gewindespindel (38) den Rand der Gerätekoffer (4) verspannt, dadurch gekennzeichnet, daß die Profilleiste (10) mit einem Anschlag (24) für den hinteren Rand (28) der Gerätekoffer (4) versehen ist, daß das Spannelement (30) um eine Achse (32) drehbar angelenkt ist und daß der Anschlag (24) und die Haltenase (34) gegenüber den Gerätekoffern (4) winklig verlaufende Flächen (26, 34) aufweisen.

2. Vorrichtung nach Anspruch 1, dadurch gekennzeichnet, daß das Spannelement (8) am Boden (12) der Profilleiste (10) drehbar befestigt ist und im zentralen Bereich des Spannelements (8) ein Langloch (40) zur Aufnahme der Gewindespindel (38) vorhanden ist, deren Gegenlager (44, 46) innerhalb der Profilleiste (10) angeordnet ist.

3. Vorrichtung nach Anspruch 2, dadurch gekennzeichnet, daß die Gewindespindel (38) mittels eines ausrastbaren Knebels (42) betätigbar ist.

## Claims

1. Device for fitting instrument cases in racks with, provided thereon, a profile strip (10) and disposed thereon and having a retaining lug (34), a clamping element (8) which engages around an edge of the instrument case (4), the clamping element (8) clamping the edge of the instrument case (4) by means of a threaded spindle (38), characterised in that the profile strip (10) is provided with an abutment (24) for the rear edge (28) of the instrument case (4), and in that the clamping element (30) is pivotally ariculated to rotate about a spindle (32), and in that the abutment (24) and the retaining lugs (34) have faces (26, 34) extending at an angle to the instrument case (4).

2. Device according to Claim 1, characterised in that the clamping element (8) is rotatably fixed to the bottom (12) of the profile strip (10) and in that there is in the central zone of the clamping element (8) an elongated hole (40) to accommodate the threaded spindle (38), the end support (44, 46) of which ist disposed inside the profile strip (10).

3. Device according to Claim 2, characterised in that the threaded spindle (38) can be actuated by means of a disengageable control lever (42).

## Revendications

1. Dispositif de fixation de coffres d'appareils dans des châssis; comportant un profilé (10) et un élément de serrage (8) placé sur lui présentant un bec de retenue (34) et s'engageant sur un bord du coffre d'appareil (4), l'élément de serrage (8) bloquant, à l'aide d'une tige filetée (38), le bord du coffre d'appareil (4), caractérisé par le fait que le profilé (10) est pourvu d'une butée (24) pour le bord arrière (28) du coffre d'appareil (4), que l'élément de serrage (30) est articulé de manière à tourner autour d'un axe (32) et que la butée (24) et le bec de retenue (34) comportent des surfaces (26, 34) inclinées par rapport au coffre d'appareil (4).

2. Dispositif selon la revendication 1, caractérisé par le fait que l'élément de serrage (8) est monté tournant sur le fond (12) du profilé (10) et qu'il est prévu dan la zone centrale de l'élément de serrage (8) un trou ablong (40) destiné à recevoir la tige filetée (38), dont le contre-appui (44, 46) est disposé à l'intérieur du profilé (10).

3. Dispositif selon la revendication 2, caractérisé par le fait que la tige filetée (38) peut être actionnée à l'aide d'une manette (42) déblocable.

Fig. 2

Fig. 1

1/1

0 015 527